# FASCICULE DE BREVET EUROPEEN

(11) **EP 1 515 438 B1**
(45) Date de publication et mention de la délivrance du brevet: **16.07.2008**
(21) Numéro de dépôt: 04104133.6
(22) Date de dépôt: 27.08.2004
(51) Int. Cl.: H03K 3/84

(54) **Génération d'un flux de bits aléatoire normalisé**
Erzeugung eines normalisierten Zufalls-Bitstroms
Generation of a normalized random bitstream

(30) Priorité: 28.08.2003 FR 0350467
(43) Date de publication de la demande: 16.03.2005
(73) Titulaire: ST MICROELECTRONICS S.A., 92120 Montrouge (FR)
(72) Inventeur: Liardet, Pierre-Yvan, 13790 PEYNIER (FR); Teglia, Yannick, 13011 MARSEILLE (FR); Tomei, Ambroise, 13100 AIX EN PROVENCE (FR)
(74) Mandataire: de Beaumont, Michel

(56) Documents cités:
- FR-A- 2 304 222
- US-A- 3 706 941
- US-A- 4 408 298
- US-A- 4 545 024
- PATENT ABSTRACTS OF JAPAN vol. 2000, no. 13, 5 février 2001 (2001-02-05) -& JP 2000 298577 A (HITACHI LTD; INST OF STATISTICAL MATHEMATICS MINISTRY OF EDUCATION), 24 octobre 2000 (2000-10-24)
- VON NEUMANN (SUMMARY BY G FORSYTHE) J: "Various Techniques Used in Connection With Random Digits" JOURNAL OF RESEARCH OF THE NATIONAL BUREAU OF STANDARDS, WASHINGTON, DC, US, vol. 5, no. 5, 1963, pages 768-770, XP002103231 ISSN: 0160-1741

## Description

La présente invention concerne le domaine des générateurs de nombres aléatoires et plus précisément les générateurs de nombres aléatoires sous la forme de flux de bits issus d'une ou plusieurs sources de bruit, numériques ou numérisées.

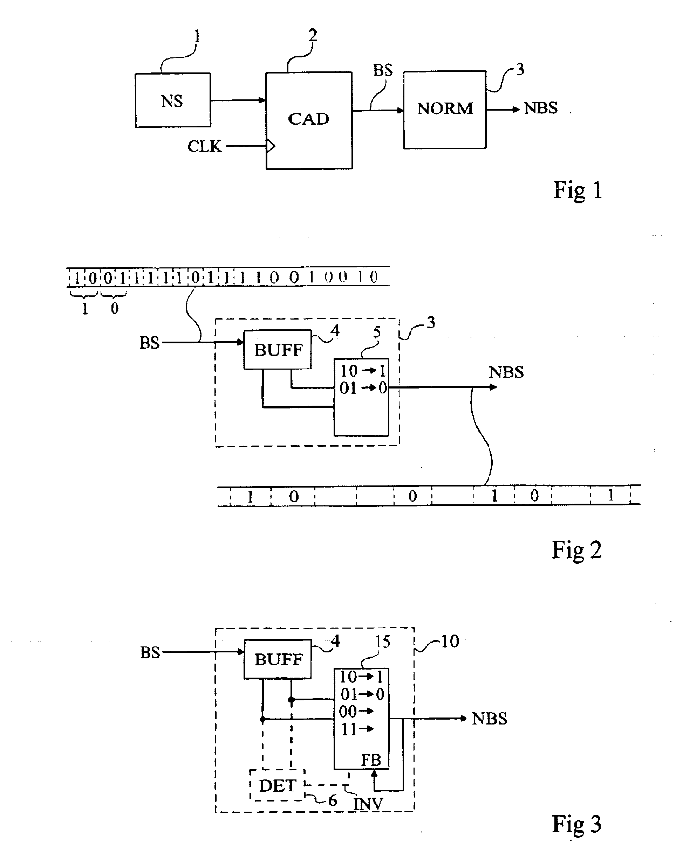

La figure 1 représente, de façon très schématique et sous forme de blocs, un exemple de générateur d'un flux de bits du type auquel s'applique la présente invention.

Un tel générateur est basé sur l'utilisation d'une source de bruit 1 (NS) fournissant un bruit analogique à un élément 2 de conversion analogique-numérique (CAD) cadencé par une horloge CLK et fournissant un flux de bits BS. La source 1 est, par exemple, constituée d'un ou plusieurs oscillateurs dont les sorties sont sommées pour fournir un bruit analogique en entrée du convertisseur 2. Le convertisseur 2 peut, de façon simplifiée, être un comparateur associé à une bascule.

La qualité d'un générateur aléatoire ou plus généralement d'une source de bruit se mesure par la qualité de son aléa, c'est-à-dire l'équiprobabilité qu'a le flux BS à fournir n'importe quel nombre et, en particulier, l'équiprobabilité de trouver dans le flux des 0 et des 1.

En pratique, le flux BS fourni par le convertisseur 2 a des risques de ne pas avoir une répartition équiprobable de ses éléments (bits ou mots de bits). En particulier, la source de bruit 1 utilise généralement des oscillateurs pour lesquels il existe un risque de synchronisation entre eux ou avec l'horloge CLK. En cas de synchronisation, l'état fourni en sortie (flux BS) reste constant.

Pour améliorer le caractère équiprobable d'un flux de bits censé être aléatoire, le flux BS traverse un circuit 3 de normalisation (NORM) fournissant un train de bit NBS modifié et dont le caractère équiprobable des zéros et des uns dans le flux est amélioré.

La figure 2 représente un exemple classique de circuit 3 de normalisation d'un flux de bit BS appliquant une méthode dite de Von Neumann. Un tel circuit 3 est basé sur une analyse du flux de bits entrant BS, par paires de bits. On utilise alors un élément de mémorisation 4 (BUFF) permettant de traiter les bits, par paires, dans un circuit 5 de détermination d'état qui fournit le flux de bits normalisé NBS. D'après la méthode de Von Neumann, si la paire de bits est 10, on génère un état 1. Si la paire de bits est 01, on génère un état 0. Si la paire de bits est 00 ou 11, on l'ignore, c'est-à-dire qu'aucun état n'est généré en sortie.

Un inconvénient de la méthode de Von Neumann est que le débit du flux de bit normalisé NBS n'est pas constant, c'est-à-dire que la période avec lesquels les bits sont fournis n'est pas régulière. Dans un circuit de Von Neumann simple tel que décrit ci-dessus, le débit de bits du flux NBS varie entre deux et quatre fois moins par rapport au débit du flux d'entrée BS.

Le document JP-A-2000/298 577 décrit un générateur de nombre aléatoire dans lequel plusieurs bits sont exploités en parallèle et conditionnant l'état d'un bit de sortie par l'état d'un bit de sortie précédent.

Le document US 3 706 941 A décrit un procédé et un circuit de normalisation d'un flux de bits issu d'une source de bruit, comportant un élément de mémorisation du flux initial pour autoriser une exploitation des bits par mots de longueurs identiques de deux bits successifs et un élément de détermination de l'état d'un bit de sortie en fonction de la combinaison des états des bits du mot courant du flux initial.

La présente invention vise à proposer une normalisation d'une source de bruit fournissant un flux de bits numérique qui améliore les solutions connues de Von Neumann.

L'invention vise plus particulièrement à rendre le débit de sortie de l'élément de normalisation constant.

L'invention vise également à accroître le débit par rapport à une normalisation de type Von Neumann.

Pour atteindre ces objets ainsi que d'autres, l'invention prévoit un procédé de normalisation d'une source de bruit fournissant un flux de bits initial, consistant :
à conditionner l'état d'un bit de sortie aux états respectifs des bits du flux initial examinés par mots de longueurs identiques ; et
à l'apparition d'un mot bits d'états identiques, à conditionner l'état du bit de sortie courant à l'état d'au moins un bit de sortie antérieur.

Selon un mode de mise en oeuvre de la présente invention, l'apparition d'un mot de bits d'états identiques conditionne en outre l'état d'un bit d'inversion du flux de sortie global.

La présente invention prévoit également un circuit de normalisation d'un flux de bit issu d'une source de bruit, comportant:
un élément de mémorisation du flux initial pour autoriser une exploitation des bits par mots de longueurs identiques de plusieurs bits successifs; et
un élément de détermination de l'état d'un bit de sortie en fonction de la combinaison des états des bits du mot du flux initial, l'état fourni à l'apparition d'un mot de bits d'états identiques étant conditionné par l'état d'au moins un bit de sortie antérieur.

Selon un mode de réalisation de la présente invention, le circuit comprend un élément de détection de mots de bits d'états identiques conditionnant une inversion des états fournis en sortie de l'élément d'affectation.

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
les figures 1 et 2 qui ont été décrites précédemment sont destinées à exposer l'état de la technique et le problème posé ; et
la figure 3 représente, de façon très schématique et sous forme de blocs, un mode de réalisation d'un circuit de normalisation selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, l'obtention du flux de bits à normaliser n'a pas été détaillée, l'invention pouvant être mise en oeuvre quel que soit ce flux et notamment qu'il ait été précédemment soumis ou non à d'autres traitements de normalisation. De même, la destination du flux de bits normalisé obtenu par l'invention est compatible avec toutes les utilisations classiques de flux de bits pour générateurs aléatoires et notamment pour une combinaison, par exemple par association en parallèle de plusieurs flux de bits, afin d'obtenir des mots aléatoires. Pour simplifier, l'invention sera décrite en relation avec un flux entrant traité par mots de deux bits consécutifs. Elle s'applique toutefois à des mots de longueur plus importante.

Une caractéristique de la présente invention est, par rapport à une méthode de normalisation de type Von Neumann, d'attribuer un état de sortie aux paires d'états identiques et de conditionner, au moins pour ces paires identiques, l'état du bit de sortie courant à l'état du bit de sortie. Selon l'invention, l'attribution d'un état aux paires d'état identiques ne s'effectue donc pas toujours de la même manière comme c'est le cas des états 01 et 10 dans une méthode de Von Neumann classique, mais va dépendre de l'état qui vient d'être fourni en sortie. Selon le mode de mise en oeuvre choisi, on attribue le même état que l'état courant ou son inverse.

Contrairement à ce que l'on pensait, il est possible d'attribuer un état de sortie aux paires de bits identiques tout en gardant un flux équiprobable, à la condition de ne pas attribuer toujours le même état de sortie à l'apparition d'un doublon d'un type (00 ou 11) donné.

La figure 3 représente, de façon très schématique et sous forme de blocs, un mode de réalisation d'un circuit de normalisation selon la présente invention.

Comme dans le cas classique de la figure 2, on mémorise (bloc 4, BUFF) au moins un bit du flux entrant BS, de façon à permettre un traitement des bits du flux par paires. Selon la manière dont sont traitées en pratique les paires de bits, on peut être conduit à mémoriser deux bits successifs du flux BS, voire plus.

Selon l'invention, un élément de détermination 15 d'état fournit un flux de bits de sortie normalisé NBS en fonction des états respectifs de la paire de bits courante du flux NS. L'élément 15 reçoit également un signal de rétroaction FB qui correspond à l'état de sortie du flux NBS.

Selon un premier mode de mise en oeuvre, le signal de rétroaction n'est pris en compte que pour déterminer les états à attribuer en présence d'un doublon 00 ou 11. Dans ce cas, les états attribués aux paires 01 et 10 sont comme dans un système classique de Von Neumann 0 et 1 (ou l'inverse). Par contre, à l'apparition d'un doublon 00 ou 11, on affecte un état 1 si le bit de sortie déterminé par la paire précédente était 0 et un état 0 dans le cas contraire.

Avec une telle réalisation, par exemple, un flux de bits entrant BS 01100001101111110100 se traduit par un flux sortant normalisé NBS 0100101001.

Selon un deuxième mode de mise en oeuvre, l'élément 15 reçoit également un signal (bit) de configuration d'inversion (INV) d'un bloc 6 (DET) de détection de doublons dans le flux de bits BS. Ce bit INV sert à provoquer l'inversion de l'état fourni pour les paires 01 et 10 à l'apparition de doublons 00 et 11. Les états des paires 01 et 10 ne seront donc pas toujours les mêmes contrairement à un système de Von Neumann classique. Par convention arbitraire pour le bit INV, on considère un état 1 comme actif et un état 0 comme inactif.

Par exemple, l'état du bit INV est inversé chaque fois qu'apparaît une paire 00 ou 11, et l'élément de détermination 15 est prévu pour fournir les états suivants :
- pour une paire entrante 01 : 0 si le bit INV est inactif, 1 dans le cas contraire ;
- pour une paire 10 : 1 si le bit INV est inactif, 0 dans le cas contraire ;
- pour une paire 00 : l'inverse de l'état du bit de sortie précédent si le bit INV est actif, l'état du bit précédent dans le cas contraire ; et
pour une paire 11: l'inverse de l'état du bit précédent si le bit INV est actif, l'état du bit précédent dans le cas contraire.

Avec une telle réalisation et en supposant, par exemple, le bit INV à l'état inactif initialement, un flux de bits entrant BS 01100001101111110100 se traduit par un flux sortant normalisé NBS 0111011000.

Pour simplifier, on a considéré que la décision quant à l'état du bit de sortie, à l'apparition d'un doublon, s'effectue avant le changement éventuel de l'état du bit INV. Le contraire est toutefois possible.

D'autres configurations de décision sont bien entendu possibles, pourvu de conditionner l'état du bit de sortie généré pour un doublon à l'état du bit de sortie précédent.

Un avantage de l'invention est que le débit du flux de bits normalisé ainsi obtenu est uniquement divisé par deux par rapport au flux d'origine.

Un autre avantage est que ce débit est constant.

Bien entendu, la présente invention est susceptible de diverses variantes et modifications qui apparaîtront à l'homme de l'art. En particulier, la mise en oeuvre pratique d'un circuit de normalisation selon l'invention, que ce soit sous forme matérielle ou logicielle, est à la portée de l'homme du métier à partir des indications fonctionnelles données ci-dessus et en utilisant des outils classiques.

De plus, bien que l'invention ait été décrite en relation avec l'exploitation de paires de bits, elle s'applique plus généralement quel que soit la longueur (paire ou impaire) des mots ou tronçons du flux entrant considérés. Par exemple, les bits entrants peuvent être traités quatre par quatre où la méthode de Von Neumann classique ne considère pas les mots de quatre bits d'états identiques (0000 et 1111). L'adaptation des modes de réalisation décrits à des mots de plus de deux bits est à la portée de l'homme du métier.

En outre, au lieu d'utiliser l'état du bit précédent, on pourra conditionner l'état du bit de sortie courant à l'état d'un bit encore antérieur ou à une fonction de plusieurs bits de sortie précédents, quelles que soient leurs positions par rapport au bit courant, pourvu d'être tous des bits antérieurs.

## Revendications

1. Procédé de normalisation d'une source de bruit fournissant un flux de bits initial (BS), dans lequel l'état d'un bit de sortie est conditionné aux états respectifs des bits du flux initial examinés par mots de longueurs identiques de plusieurs bits successifs, **caractérisé en ce que**
l'apparition d'un mot de bits d'états identiques conditionne l'état du bit de sortie courant à l'état d'au moins un bit de sortie antérieur.

2. Procédé selon la revendication 1, dans lequel l'apparition d'un mot de bits d'états identiques conditionne en outre l'état d'un bit d'inversion (INV) du flux de sortie global (NBS).

3. Circuit de normalisation d'un flux de bits issu d'une source de bruit, comportant:
un élément (4) de mémorisation du flux initial pour autoriser une exploitation des bits par mots de longueurs identiques de plusieurs bits successifs ; et
un élément (15) de détermination de l'état d'un bit de sortie en fonction de la combinaison des états des bits du mot courant du flux initial, l'état fourni à l'apparition d'un mot de bits d'états identiques étant conditionné par l'état d'au moins un bit de sortie antérieur.

4. Circuit selon la revendication 3, comprenant un élément (6) de détection de mots de bits d'états identiques (00, 11) conditionnant une inversion des états fournis en sortie de l'élément d'affectation (15).

5. Circuit selon la revendication 3 pour la mise en oeuvre du procédé selon la revendication 1 ou 2.

## Claims

1. A method for normalizing a noise source providing an initial bit flow (BS), wherein the state of an output bit is conditioned to the respective states of the bits of the initial flow examined by multibit words of identical lengths, **characterized in that** the occurrence of a word of bits of identical states, conditions the state of the current output bit to the state of at least one previous output bit.

2. The method of claim 1, in which the occurrence of a word of bits of identical states further conditions the state of an inversion bit (INV) of the general output flow (NBS).

3. A circuit for normalizing a bit flow coming from a noise source, comprising:
an element (4) for storing the initial flow to authorize an exploitation of the bits by words of identical length of several successive bits; and
an element (15) for determining the state of an output bit according to the combination of the states of the bits of the current word of the initial flow, the state provided upon occurrence of a word having bits of identical states being conditioned by the state of at least one previous output bit.

4. The circuit of claim 3, comprising an element (6) for detecting words having bits of identical states (00, 11) conditioning an inversion of the states provided at the output of the assignment element (15).

5. The circuit of claim 3, for the implementation of the method of claim 1 or 2.

## Patentansprüche

1. Verfahren zum Normalisieren einer Schallquelle, die einen Initialisierungs- bzw. Anfangsbitfluss (BS) liefert, wobei der Zustand eines Ausgangsbits auf jeweilige Zustände der Bits des Anfangsflusses konditioniert ist, der durch Multi-Bit-Worte von gleicher Länge untersucht ist,
**dadurch gekennzeichnet, dass**
das Auftreten eines Bit-Wortes mit gleichen Zuständen den Zustand des gegenwärtigen Ausgangsbits auf den Zustand von mindestens einem vorherigen Ausgangsbit konditioniert.

2. Verfahren nach Anspruch 1, wobei das Auftreten eines Bit-Wortes mit identischen Zuständen unter anderem den Zustand eines Inversionsbits (INV) des allgemeinen Ausgangsflusses (NBS) konditioniert.

3. Normalisierungsschaltung für einen Bitfluss, der aus einer Schallquelle ausgegeben wird, die Folgendes aufweist:
ein Element (4) zur Speicherung des Anfangsflusses, um einen Nutzung der Bits durch Worte von identischer Länge von mehreren aufeinander folgenden Bits zu autorisieren; und
ein Element (15) zur Bestimmung des Zustandes eines Ausgangsbits als Funktion der Kombination der Zustände der Bits des gegenwärtigen Wortes des Anfangsflusses, wobei der beim Auftreten eines Wortes mit Bits mit gleichen Zuständen gelieferte Zustand durch den Zustand von mindestens einem vorherigen Ausgangsbit konditioniert bzw. bestimmt wird.

4. Schaltung nach Anspruch 3, welche ein Element (6) zum Detektieren von Worten mit Bits mit identischen Zuständen (00, 11) aufweist, welches eine Umkehrung der gelieferten Zustände am Ausgang des Zuordnungselementes (15) konditioniert bzw. bestimmt.

5. Schaltung nach Anspruch 3, um ein Verfahren nach Anspruch 1 oder 2 einzurichten.
